(19)

Europäisches Patentamt
European Patent Office
Office européen des brevets

(11) **EP 3 445 069 A1**

(12) **EUROPEAN PATENT APPLICATION**

(43) Date of publication:
**20.02.2019 Bulletin 2019/08**

(51) Int Cl.:
**H04S 7/00** *(2006.01)*    *H03G 5/16 (2006.01)*

(21) Application number: **17186678.3**

(22) Date of filing: **17.08.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Harman Becker Automotive Systems GmbH**
**76307 Karlsbad (DE)**

(72) Inventor: **CHRISTOPH, Markus**
**94315 Straubing (DE)**

(74) Representative: **Bertsch, Florian Oliver**
**Kraus & Weisert**
**Patentanwälte PartGmbB**
**Thomas-Wimmer-Ring 15**
**80539 München (DE)**

(54) **ROOM-DEPENDENT ADAPTIVE TIMBRE CORRECTION**

(57) The present invention relates to a method and system for correcting acoustical characteristics of a sound signal in a listening environment caused by changes of spatial characteristics of the listening environment. Therein, a reference room transfer function of the listening environment is provided, and a changed room transfer function is adaptively determined, which is caused by changes of spatial characteristics of the listening environment. Further, equalizing parameters are determined for the sound signal based on the reference room transfer function using the changed room transfer function, in order to compensate for the changed room transfer function.

FIG. 6

EP 3 445 069 A1

**Description**

Technical field

The present invention relates to a method and system for correcting audio characteristics of a sound signal in a listening environment, in particular to a method and system for correcting acoustical characteristics of a sound signal in a listening environment caused by changes of spatial characteristics of the listening environment.

Background

Acoustics in a listening environment, such as a room are commonly investigated. In particular, room acoustics in small rooms, such as the interior of an automobile, represent a challenging situation that often requires specific solutions to ensure excellent audio quality for an audience or listener.

In such small rooms, it often appears that spatial room characteristics variably change, this is the case, for example, if the room is fully or just partly occupied, if one or more windows are open or closed or if other openings such as the trunk or the sun-roof is open or closed. Depending on these spatial room characteristics the resulting acoustical room characteristics, i.e. the room-transfer functions, inevitably change, leading to an undesired, acoustical coloration, differing from reference conditions, i.e. the underlying tuning, which was usually defined with fixed room characteristics, such as a quiet environment with all openings closed and only one person sitting at the driver's seat.

Current implementations of so-called automatic equalization algorithms, for example "AutoEq", usually try to fit an acoustic system, at one or several points in the room, e.g. head respectively ear positions, to a previously defined target function. Usually the target function represents a desired room transfer function, defining desired acoustical characteristics, such as the timbre. In the course of this principle, it is normal to apply, in general mixed-phase, equalizing parameters, e.g. which are used in an equalizing filter, to each of the acoustically contributing output channels. Thus, the automatism changes both magnitude and phase of each channel to reach the aim, i.e. to match the measured room transfer functions to the target function.

Different so-called AutoEq algorithms do exist, but they are usually only able to automatically adjust the timbre and do either lack in adjusting other acoustical properties, such as ASW or LEV, stage-width, distance to the stage, acoustical engulfment, localization, or affect such already optimized/tuned additional acoustical properties. Thus, the focus is only on the timbre, ignoring or sacrificing other also very important properties of a desired sound field.

In this regard, the document EP 1 619793 A1 describes a method according to which a timbre is dynamically changed depending on a background noise, wherein the background noise is continuously estimated using one or more microphone measurements in the interior of an automobile.

In principle, the so-called acoustic pressure chamber effect is more prevalent, the smaller the effective volume of the room is, in which the wave propagation takes place. If an acoustic wave is larger than the dimensions of the room in which it is generated, propagation of the wave is not possible. This results in the formation of the pressure chamber effect, as an increased sound pressure due to standing waves. Thus, if for example by opening one or more windows, the volume of the room is increased, then the sound pressure level (SPL) is instantaneously lowered. This effect predominantly takes place in the frequency range, in which the wavelengths are large in relation to the dimensions of the room, therefore in the lower frequency range.

Acoustically, this is noticeable by a changed timbre of the sound, in particular such effect is clearly noticeably when listening to male voices. In the mid-range region, timbre changes also occur, wherein, in particular, a loss in performance caused by the change in the reflecting surfaces, occurs.

The method according to the invention can in particular be applied in sound systems consisting of more than one output channel, such as vehicle audio systems and producers of home entertainment systems able to create stereo or surround-sound.

Summary

Accordingly there is a need to provide a method and system for correcting audio characteristics of a sound signal in a listening environment, which can precisely and effectively maintain predetermined audio characteristics.

This need is met by the subject matter of the independent claims. Further advantageous features are subject matter of the dependent claims.

According to a first aspect of the invention, a method for correcting audio characteristics of a sound signal in a listening environment is provided. According to the method, in a first step, a reference room transfer function of the listening environment is provided. In a further step, a changed room transfer function is adaptively determined, wherein the changed room transfer function is different from the reference room transfer function and is caused by changes of spatial characteristics of the listening environment. According to the invention, the changed room transfer function can also be mainly caused by changes of spatial characteristics of the listening environment. In an additional step, equalizing parameters are determined for the sound signal based on the reference room transfer function using the changed room transfer function, in order to compensate for the changed room transfer function. In a further step, the determined equalizing parameters are applied to the sound signal.

Thereby, an improved method for correcting audio characteristics of a sound signal in a listening environment is provided, which corrects audio characteristics of a sound signal in a listening environment caused by changes of spatial characteristics of the listening environment. The disclosed method is able to recognize deviations from a previously defined reference and is able to automatically equalize it, such that as a result the same audio characteristics, such as the same timbre can be reached, independent of the current spatial characteristics of the listening environment.

Furthermore, the method can advantageously be used as add-on in combination with an already equalized sound system. Hence, an isolated correction of audio characteristics, such as the timbre, can be done, by applying the automatically calculated equalizing parameters equally to all output channels. In the method according to the invention, the phase of the equalizing filter does not matter. In particular, all acoustical properties won't be touched, changed or in some way modified, i.e. all the above mentioned, important, acoustical properties which exist beside the timbre, such as the auditory source width, the listener envelopment and such will remain as they are. Therefore, according to the invention an automated adjustment of audio characteristics, such as the timbre of an audio signal, can be reached, without affecting all other phase based acoustic properties, such as the ASW, LEV or localization.

According to a second aspect of the invention, a system for correcting audio characteristics of a sound signal in a listening environment is provided, wherein the system comprises the following elements. A data storage is configured to provide a reference room transfer function of the listening environment. A room transfer function determination module is configured to adaptively determine a changed room transfer function, wherein the changed room transfer function is caused by changes of spatial characteristics of the listening environment and different from the reference room transfer function. An equalizing parameter determination module is configured to determine equalizing parameters based on the reference room transfer function using the changed room transfer function. And an equalizing parameter application module is configured to apply the equalizing parameters to the sound signal, in order to correct audio characteristics of the sound signal.

According to a third aspect of the invention, a further system for correcting audio characteristics of a sound signal in a listening environment is provided, wherein the system comprises data storage, at least one audio loudspeaker for generating a sound output from a sound signal, least one sensor for obtaining a total sound signal representative of the total sound level in said environment, a memory configured to store program code, and least one processor coupled with the memory. Therein, the at least one processor is configured to execute the program code, wherein execution of the program code causes the at least one processor to perform the following steps. In a first step, a reference room transfer function of the listening environment is provided. In a further step, a changed room transfer function is adaptively determined, wherein the changed room transfer function is different from the reference room transfer function and is caused by changes of spatial characteristics of the listening environment. In an additional step, equalizing parameters are determined for the sound signal based on the reference room transfer function using the changed room transfer function, in order to compensate for the changed room transfer function. In a further step, the determined equalizing parameters are applied to the sound signal.

The system for correcting audio characteristics of a sound signal in a listening environment describe in the second and third aspects of the invention can be configured to perform the method described in the first aspect of the invention above. For such systems for correcting audio characteristics of a sound signal in a listening environment, technical effects can be achieved, which correspond to the technical effects described for the method for correcting audio characteristics of a sound signal in a listening environment according to the first aspect of the invention.

According to a fourth aspect of the invention, a vehicle is provided, wherein the vehicle comprises a system for correcting audio characteristics of a sound signal in a listening environment as described in the second and third aspects of the invention.

Although specific features described in the above summary and the following detailed description are described in connection with specific embodiments and aspects of the present invention, it should be understood that the features of the exemplary embodiments and aspects may be combined with each other unless specifically noted otherwise.

Brief description of the drawings

The present invention will now be described in more detail with reference to the accompanying drawings.

Figure 1a    illustrates a measurement diagram with a sound pressure level (SPL) measured in a vehicle with a subwoofer and the left window open and closed (acting as reference), as known in the art;

Figure 1b    illustrates the SPL difference between the reference SPL measurement and the SPL measurement with the left window open of Figure 1a, as known in the art;

Figure 2a     illustrates a measurement diagram with a sound pressure level (SPL) measured in a vehicle with a subwoofer and the right window open and closed (acting as reference), as known in the art;

Figure 2b     illustrates the SPL difference between the reference SPL measurement and the SPL measurement with the right window open of Figure 2a, as known in the art;

Figure 3a     illustrates a measurement diagram with a sound pressure level (SPL) measured in a vehicle with a subwoofer and both windows open and closed (acting as reference), as known in the art;

Figure 3b     illustrates the SPL difference between the reference SPL measurement and the SPL measurement with both windows open of Figure 3a, as known in the art;

Figure 4a     illustrates a measurement diagram with a sound pressure level (SPL) measured in a vehicle with an audio system (all speakers active) and the left window open and closed (acting as reference), as known in the art;

Figure 4b     illustrates the SPL difference between the reference SPL measurement and the SPL measurement with the left window open of Figure 4a, as known in the art;

Figure 5     illustrates a schematic drawing of an adaptive room transfer function determination module in the time domain, as known in the art;

Figure 6     illustrates a schematic drawing of a system for correcting audio characteristics of a sound signal in a listening environment, according to embodiments of the invention;

Figure 7     illustrates a schematic drawing of a system for correcting audio characteristics of a sound signal in a listening environment in the spectral domain, according to embodiments of the invention;

Figure 8     illustrates a schematic drawing of a system for correcting audio characteristics of a sound signal in a listening environment combined with a DEC system, according to embodiments of the invention;

Figure 9     illustrates a schematic drawing of a system for correcting audio characteristics of a sound signal in a listening environment combined with an ALC system, according to embodiments of the invention;

Figure 10     illustrates a schematic drawing of a system for correcting audio characteristics of a sound signal in a listening environment, according to embodiments of the invention;

Figure 11     illustrates a flowchart with steps for performing a method for correcting audio characteristics of a sound signal in a listening environment, according to embodiments of the invention;

Detailed description of the embodiments

In the following, concepts in accordance with exemplary embodiments of the invention will be explained in more detail and with reference to the accompanying drawings.

The drawings are to be regarded as being schematic representations and elements illustrated in the drawings are not necessarily shown to scale. Rather, the various elements are represented such that their function and general purpose become apparent to a person skilled in the art. Any connection or coupling between functional blocks, devices, components, modules or other physical or functional units shown in the drawings or described herein may also be implemented by an direct or indirect connection or coupling. A coupling between components may also be established over a wireless connection. Functional blocks may be implemented in hardware, firmware, software, or a combination thereof.

Hereinafter, various techniques with respect to employing a method and system for correcting audio characteristics of a sound signal in a listening environment are described. In some examples, the system for correcting audio characteristics of a sound signal in a listening environment may be employed in a vehicle such as a passenger vehicle. Therein, the above-described effect of decreased sound pressure levels, and thereby varied audio characteristics, such as the timbre, within a listening environment caused by changing room characteristics will be investigated by means of example measurements with vehicle and audio system as known in the art. Based on the results obtained, a method and system for correcting audio characteristics of a sound signal in a listening environment are presented with which this effect can be mitigated or completely compensated.

For the above described example measurements, the influence of changed room volume couplings in a passenger vehicle was examined. A microphone was placed on head height at the seat at the front left position. A subwoofer was positioned in the front-right footwell. The subwoofer was fed with pink noise, whereby following setups were measured:

1. Front left window fully open,
2. front right window fully open,
3. front left and right windows fully open, and
4. reference setup with all windows closed.

Therein, pink noise refers to a signal with a frequency spectrum such that the power spectral density is inversely proportional to the frequency of the signal. In pink noise, each halving/doubling in frequency carries an equal amount of noise energy. Other signals can be used for the measurement as known in the art, which have different intensity distributions over frequency.

In addition, the effect was also examined using an audio system onboard the vehicle, wherein pink noise at 20 dB under full sound pressure level was broadcast from a Compact Disc (CD) with the following measurement setups:

5. Front left window fully open, and
6. reference setup with all windows closed.

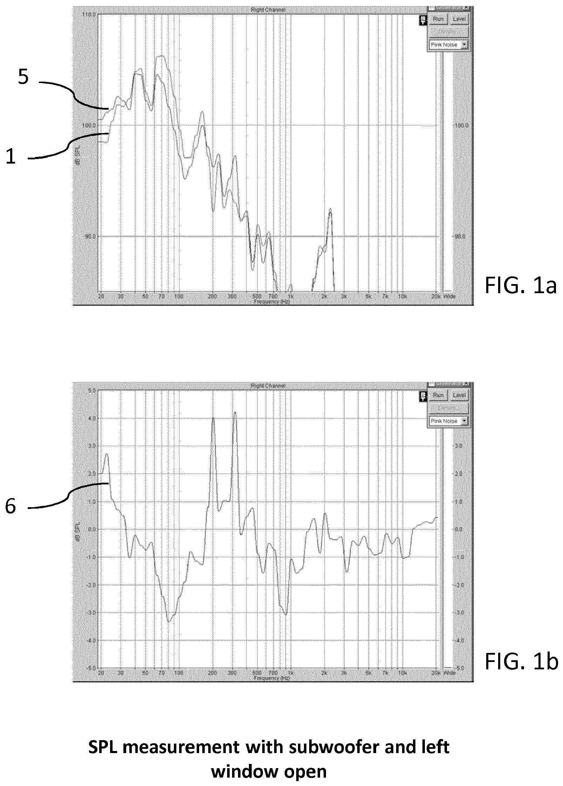

The measurement results of the above measurement setups are discussed in the following with reference to Figures 1a to 4b.

Figure 1a illustrates a measurement diagram with a sound pressure level (SPL) measured in a vehicle with a subwoofer and the left window open and closed (as reference), as known in the art. Therein, measurement line 5 represents a reference measurement of the SPL over frequency with all windows of the vehicle fully closed. Measurement line 1 represents the SPL over frequency with the left window of the vehicle fully open.

Figure 1b illustrates the SPL difference between the reference SPL measurement 5 and SPL measurement 1 with the left window open shown in Figure 1a, as known in the art.

As can be seen from Figure 1b, there is a loss of the sound pressure level in SPL measurement 1 substantially over the complete spectral range, when the left window is fully open. Therein, the loss of sound pressure level in SPL measurement line 1 is barely present in very low frequencies of the frequency range, and further decreases with increasing frequency.

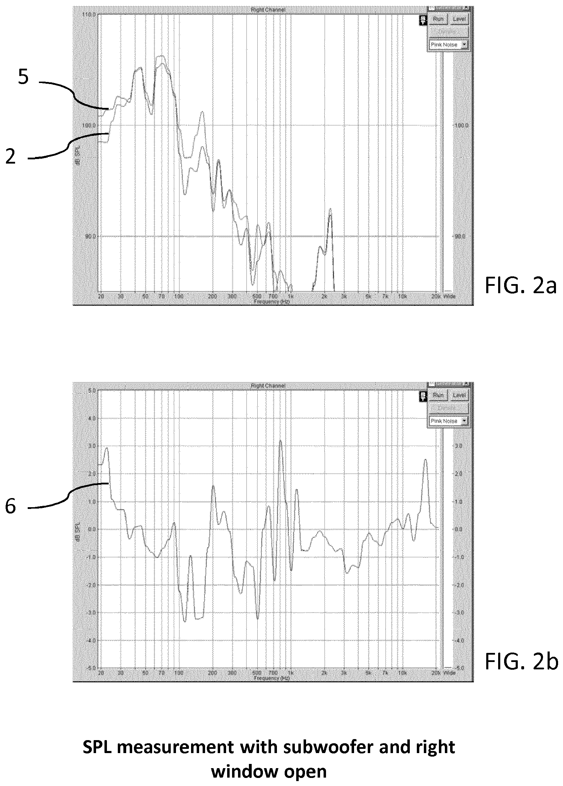

Figure 2a illustrates a measurement diagram with a sound pressure level (SPL) measured in a vehicle with a subwoofer and the right window open and closed (reference), as known in the art. Therein, measurement line 5 represents the reference measurement of the SPL over frequency with all windows of the vehicle fully closed. Measurement line 2 represents the SPL over frequency with the right window of the vehicle fully open.

Figure 2b illustrates the SPL difference between reference SPL measurement 5 and SPL measurement 2 with the left window fully open of Figure 2a, as known in the art.

As can be seen in Figures 2a and 2b the loss of sound pressure level over frequency is substantially different from the loss of pressure level over frequency shown in Figures 1a and 1b, when the room volume is changed at another location of the vehicle. In principle it, the spectral and thereby acoustic effects are stronger, when the room volume changes are closer located to the location of the listener, i.e. the microphone. Also in this case, it is clear that the loss of sound pressure level depicted in Figures 1a and 1b, where the room volume change is located in close proximity to the microphone, is bigger than the loss of sound pressure level depicted in Figures 2a and 2b, where the room volume change is located on an opposite side of the vehicle. Further, also in this measurement set up, the reduction of the sound pressure level decreases with increasing frequency.

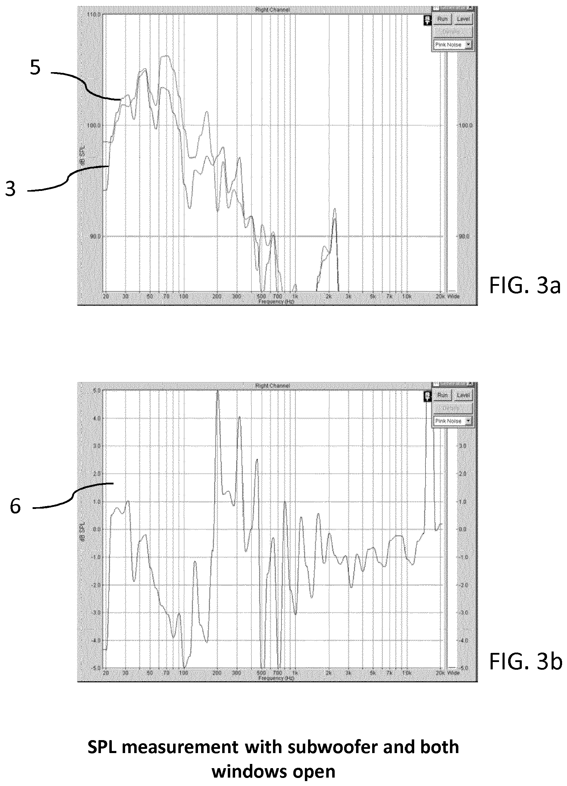

Figure 3a illustrates a measurement diagram with a sound pressure level (SPL) measured in a vehicle with a subwoofer and both windows open and closed (reference), as known in the art. Therein, measurement line 5 represents the reference measurement of the SPL over frequency with all windows of the vehicle fully closed. Measurement line 3 represents the SPL over frequency with both windows of the vehicle fully open.

Figure 3b illustrates the SPL difference between reference SPL measurement 5 and SPL measurement 3 with both windows fully open of Figure 3a, as known in the art.

As can be derived from Figures 3a and 3b, the change of sound sound pressure level is the bigger, the bigger the spatial change of the room volume is. Other than in measurement setups of Figures 1a to 2b, in this case both windows were fully opened.

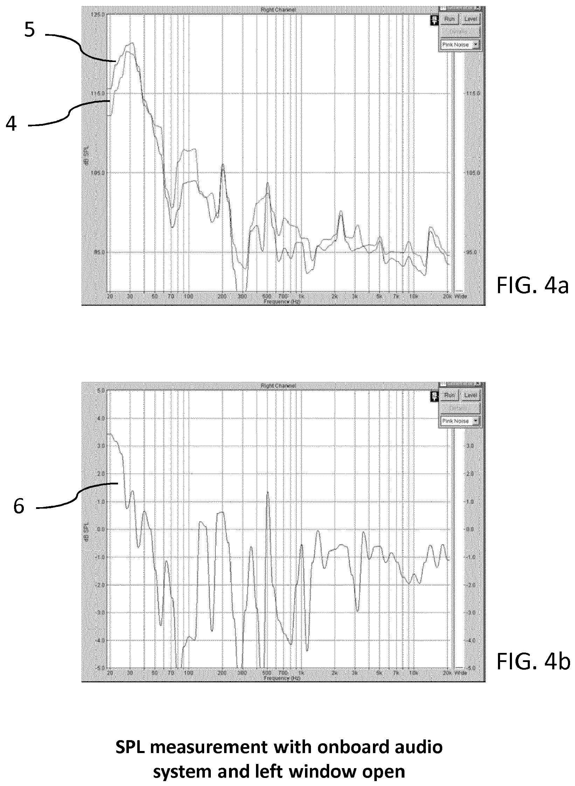

Figure 4a illustrates a measurement diagram with a sound pressure level (SPL) measured in a vehicle with an audio system and the left window open and closed (reference), as known in the art. Therein, measurement line 5 represents a reference measurement of the SPL over frequency with all windows of the vehicle fully closed. Measurement line 4 represents the SPL over frequency with the left window of the vehicle fully open.

Figure 4b illustrates the SPL difference between reference SPL measurement 5 and the SPL measurement 4 with the left window open of Figure 4a, as known in the art.

As can be seen in figures 4a and 4b, that the change of the room volume has an effect substantially in the frequency range below $f = 1$ [$kHz$]. However, also in the frequency range above $f = 1$ [$kHz$] there is a reduction of the sound pressure levels, wherein this reduction is firstly generally lower and on secondly generally independent of the frequency, and therefore, it does not substantially contribute to a variation of the timbre of the sound signal broadcasted during measurement.

It can be concluded, that acoustically relevant changes of sound pressure levels, which are caused by changes of the room volume, occur predominantly below the frequency $f = 1$ [$kHz$].

In the following, a method will be proposed to correct room-dependent variations of the timbre of a sound signal caused by changes of the spatial characteristics of a listening environment.

It is the aim of the method according to the invention presented below to maintain a known reference room as far as possible, irrespective of the currently prevailing spatial characteristics.

Since acousticians spend about 80% of their work time on the driver's seat, it is also useful to measure the room impulse response (RIR) as close to their ears as possible at the time of their work. Acoustic tuning of vehicles always takes place with fully enclosed vehicles, wherein mostly one person is in the driver's position.

It is therefore possible to use the resulting RIR of all loudspeakers as a reference. It is, of course, also possible to record a plurality of references at different seat positions, whereby an individualization of the correction of room-dependent timbre variations is achieved.

For the solution of the problems described above, it is necessary to continuously, i.e. in real time, monitor the spatial characteristics in the form of the RIRs at the seating positions. Differences between the reference room impulse responses and the continuously estimated RIRs, which are caused by variations of spatial characteristics of the room, then directly result in the necessary correction filters, which should ensure that the timbre, due to changes of spatial characteristics, does not change subjectively.

With regard to the described method and system, spatial characteristics herein refer to changes of the room volume of a listening environment, in particular the amount or measure of the volume of the room, which can be changed by opening or closing parts of the enclosure of the room volume, i.e. by changing room couplings. Further, spatial characteristics of the listening environment also refer to the form of the room volume, i.e. the form of the inner space which includes the room volume, which can e.g. be changed by a passenger seat order or distribution of load in relation to a loudspeaker. Therein, equalizing parameters are used in sound reproduction to alter the frequency response of an audio system by boosting or attenuating a signal over a frequency range by a desired gain.

The object of the method according to the invention described here is to react exclusively to changes of spatial characteristics, i.e. changing external conditions, such as the ambient noise or the excitation signal, should not lead to a timbre correction.

Corresponding methods are already available for such external influences, such as the initially described Dynamic Equalization Control (DEC) system for the dynamic compensation of ambient noise as described for example in the document EP 1 619793 A1 and the automatic loudness control (ALC) algorithm for compensation differences in the loudness of excitation signals as described for example in the document WO 2015/010865 A1.

As will be described in the following, the method according to the invention, which is hereinafter referred to as Room-Dependent Adaptive Timbre Correction (RATC), can be easily integrated into a signal processing method as the automatic loudness control (ALC) method as described in the document WO 2015/010865 A1.

The basic idea of the RATC principle, as described above, is that changes of spatial characteristics of a listening environment with respect to one or more reference conditions (reference room impulse responses) are automatically compensated. Figures 1b, 2b, 3b and 4b already provide the result (albeit with the opposite sign) of the RATC algorithm, i.e. the equalization setting for the necessary timbre change (equalization) caused by the changes of spatial characteristics of the listening environment.

In the following the known Double Talk Detection (DTD) problem occurring within the RATC method will be discussed.

One of the difficulties encountered in the RATC method is to robustly estimate the RIR respectively the RIRs, i.e. without being negatively affected by external influences, such as background noise, which degrade the signal-to-noise ratio (SNR). Without countermeasures, external influences, including impulse-like disturbances such as speech or the slamming of a door, would cause the currently estimated RIR to be destroyed. The RIR then takes some time to adapt again. During this time, inevitably a wrong equalization would be applied to the sound signal and thus a falsified timbre created, which must be prevented in any case.

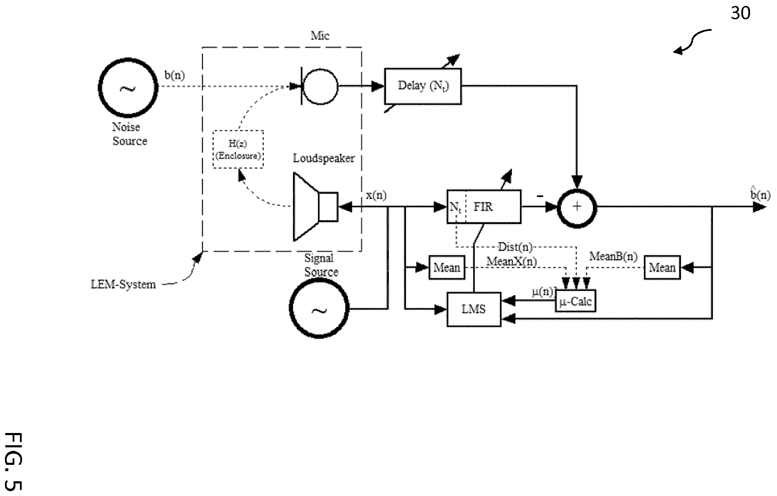

Possibilities for solving this problem, which is also called Double Talk Detection (DTD), are known for example from the document EP 1 619793 A1, wherein the precursor coefficient method according to Yamamoto, which is known in the art and described in the document "An adaptive echo canceller with variable step gain method" by Yamamoto, S., Kitayama, S., Tamura, J. and Ishigami, H. (1982), is used. The method according to Yamamoto is schematically shown in Figure 5, and is included here as an example for a plurality of algorithms for adaptive adjustment of an adaptation step size as known in the art.

Figure 5 illustrates a schematic drawing of a room transfer function determination module, as known in the art.

Depicted in Figure 5 is a signal flow diagram of an adaptive system using the precursor coefficient method the precursor coefficient method according to Yamamoto for the adaptive estimation of an unknown room impulse response using the Normalized Least Mean Squared (NLMS) algorithm.

Mathematically, the adaptive filtering in the time domain can be represented by the NLMS algorithm as follows:

$$\hat{d}(n) = \hat{\boldsymbol{h}}^T(n)\, \boldsymbol{x}(n),$$

$$\hat{b}(n) = e(n) = \hat{d}(n) - y(n),$$

$$\hat{\boldsymbol{h}}(n+1) = \hat{\boldsymbol{h}}(n) + \mu(n)\frac{e(n)\,\boldsymbol{x}(n)}{\|\boldsymbol{x}(n)\|^2}$$

Therein, the following relations apply:

$$\hat{\boldsymbol{h}}(n) = \quad \left[\hat{h}_0(n), \hat{h}_1(n), \dots, \hat{h}_{N-1}(n)\right]^T,$$

$$\boldsymbol{x}(n) = \quad \left[x(n), x(n-1), \dots, x(n-N-1)\right]^T,$$

| | |
|---|---|
| $N =$ | FIR filter length |
| $\hat{d}(n) =$ | $n$-th sample of the estimated echo signal (desired response) |
| $\hat{h}(n) =$ | filter coefficients of the adaptive (FIR) filter at the time (sample) $n$ |
| $x(n) =$ | input signal with length N at the time (sample) $n$ |
| $\hat{b}(n) = e(n) =$ | $n$-th sample of the error signal |
| $y(n) =$ | $n$-th sample of the output signal of the adaptive (FIR) filter |
| $\mu(n) =$ | adaptive step size at the time (sample) $n$ |
| $\|\mathbf{x}\|^2 =$ | $L^2$ norm of the vector $\mathbf{x}$ |
| $(x)^T =$ | transpose of the vector $\boldsymbol{x}$ |

The determination of the adaptive adaption step size, which is referred to as $\mu(n)$ in the above relations, can be realized using the precursor coefficient method, as described here and known in the art.

The precursor coefficient method can be summarized mathematically as follows:

$$\mu(n) = \quad Dist(n)\, SNR(n),$$

$$Dist(n) = \quad \frac{1}{N}\sum_{i=1}^{N_t}\left|\hat{h}_i(n)\right|,$$

$$SNR(n) = \quad \frac{\overline{|x(n)|}}{\overline{|\hat{b}(n)|}}$$

with

$$\overline{|x(n)|} = \alpha_x |x(n)| + (1 - \alpha_x) \overline{|x(n-1)|},$$

$$\overline{|\hat{b}(n)|} = \alpha_{\hat{b}} |\hat{b}(n)| + (1 - \alpha_{\hat{b}}) \overline{|\hat{b}(n-1)|},$$

Therein further the following relations apply:

$Dist(n) =$　estimated system distance (difference between estimated RIR and actual RIR) at the time (sample) $n$

$SNR(n) =$　estimated signal to noise ratio at the time (sample) $n$

$N_t =$　number of filter coefficients of the adaptive (FIR) filter, which are to be used as precursor coefficients ($N_t = [5,...,20]$)

$\overline{|x(n)|} =$　smoothed input signal $x(n)$ at the time (sample) $n$

$\overline{|\hat{b}(n)|} =$　smoothed error signal $\hat{b}(n)$ at the time (sample) $n$

$\alpha_x =$　smoothing coefficient for the input signal $x(n)$

$\alpha_{\hat{b}} =$　smoothing coefficient for the error signal $\hat{b}(n)$

As can be seen from the above formula, the adaptive adaption step size is determined in principle by the product of the estimated current signal-to-noise ratio $SNR(n)$ and the estimated current system distance $Dist(n)$.

The current signal-to-noise ratio $SNR(n)$ can be simply determined from the ratio of the smoothed magnitude of the input signal $\overline{|x(n)|}$ representing the "signal" in the $SNR(n)$ and the smoothed magnitude of the error signal $\overline{|\hat{b}(n)|}$, which corresponds to the "noise" in the $SNR(n)$.

These signals can be provided by any adaptive method and thus are not a major challenge to signal processing. The peculiarity of the precursor coefficient method is how the system distance is estimated. As shown in Figure 5, a defined delay with a length of $N_t$ samples is introduced into the microphone path. This results in the fact that information about the current adaptation success can be derived based on a certain part of the adaptive filter, more precisely the first $N_t$ coefficients of the FIR filter, since it is known for this range that it must become ideally zero, because the adaptive filter must realize a delay line of $N_t$ coefficients which, as is known in the art, is formed by $N_t$ zeros. Thus, the magnitude mean value of the first $N_t$ filter coefficients, which ideally are zero as described above, represents an indicator for the system distance, that is, for the deviation of the currently estimated RIR to the actually present RIR.

Other methods, such as the purely statistical method according to the document "Robust and elegant, purely statistical adaptation of acoustic echo canceller and postfilter" by Enzner, G. and Vary, P. (2003) use a different method for estimating the system distance. As already mentioned, however, the basic idea remains the same in all these processes, which is why this type of algorithms is not further addressed at this point.

Summarizing, a AEC system is used to adaptively continuously determine the RIRs of the listening environment, wherein a RIR is independent from other disturbances like background noise if the adaptive step size adaption works in an ideal way.

By using an adaptive adaptation step size $\mu(n)$, a way has been shown to solve the aforementioned DTD problem. Thus, it is also possible under real conditions, e.g. under the influence of impulse-like disturbances or strong background noise, to robustly estimate the RIR, whereby acoustically distorting equalization can be avoided. In the following the fader balance problem occurring within the RATC method will be discussed.

Another problem occurs when the operator is using the fader balance controls. This results in a change in the resulting RIR, which is known to be composed of the RIRs between all the loudspeakers and the microphone at the reference position. The problem can be solved by placing a separate reference room impulse response in the memory for each possible combination of the fader / balance setting, which is then accessed when this setting is changed.

However, since this requires a lot of memory, it is advisable to use a more efficient variant.

First of all, it can be stated that the listener is interested in a subjectively constant timbre. This means that if all channels or loudspeakers are modified with the same equalizing filter at the same time, then only a variation of timbre occurs. Other effects, e.g. phase changes do not occur. For this reason, instead of the RIRs, it is also possible to store only their magnitude frequency responses in the data storage, i.e. to omit the phase information. However, it is still unclear whether this measure alone will save enough memory.

Additionally, by using principles of psychoacoustics, as for example the use of an acoustically correct division of the frequency range into frequency bands, such as in the Bark, Mel or the Equivalent Rectangular Bandwidth (ERB) Scale, the information content to be stored can be significantly reduced. When using the Bark Scale, only 24 averaged values of the magnitude frequency response are to be stored for the representation of a reference room transfer function.

Accordingly it is possible to store one (or several) own reference values in the memory for each fader / balance combination without overloading the memory.

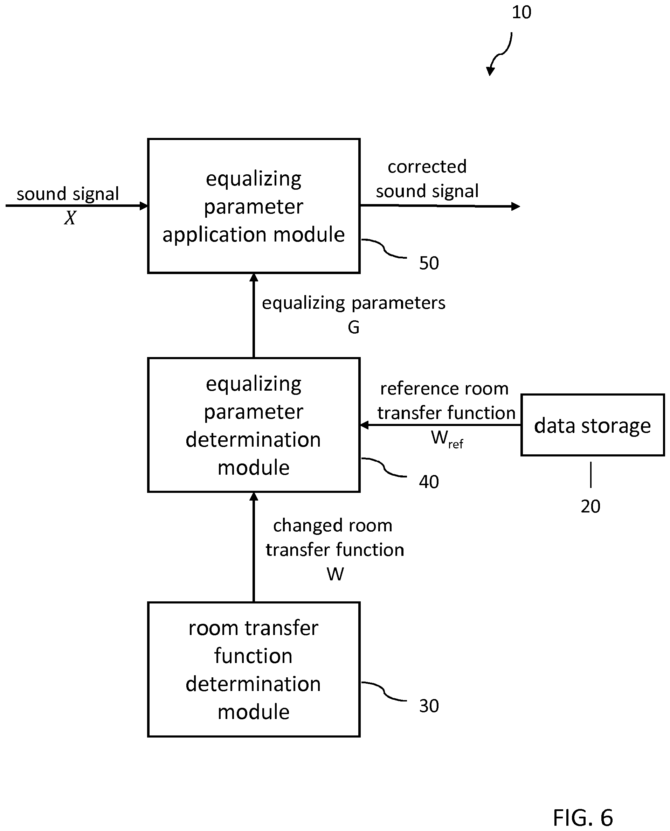

Figure 6 illustrates a schematic drawing of a system for correcting audio characteristics of a sound signal in a listening environment, according to embodiments of the invention.

The system for correcting audio characteristics of a sound signal in a listening environment 10 as depicted in Figure 6 comprises a data storage 20, which is configured to provide a reference room transfer function $W_{ref}$ of the listening environment W to an equalizing parameter determination module 40. The system 10 further comprises a room transfer function determination module 30, which is configured to adaptively determine and provide a changed room transfer function W to an equalizing parameter determination module 40, wherein the changed room transfer function W is caused by changes of spatial characteristics of the listening environment and different from the reference room transfer function $W_{ref}$. The system 10 furthermore comprises equalizing parameter determination module 40, which is configured to determine and provide equalizing parameters G to an equalizing parameter application module 50, which is configured to apply the equalizing parameters to the sound signal, based on the reference room transfer function $W_{ref}$ using the changed room transfer function W, in order to correct audio characteristics of the sound signal X and provide a corrected sound signal for broadcast in the listening environment. Therefore, the corrected sound signal has the same audio characteristics as in the reference environment characterized by the reference room transfer function $W_{ref}$.

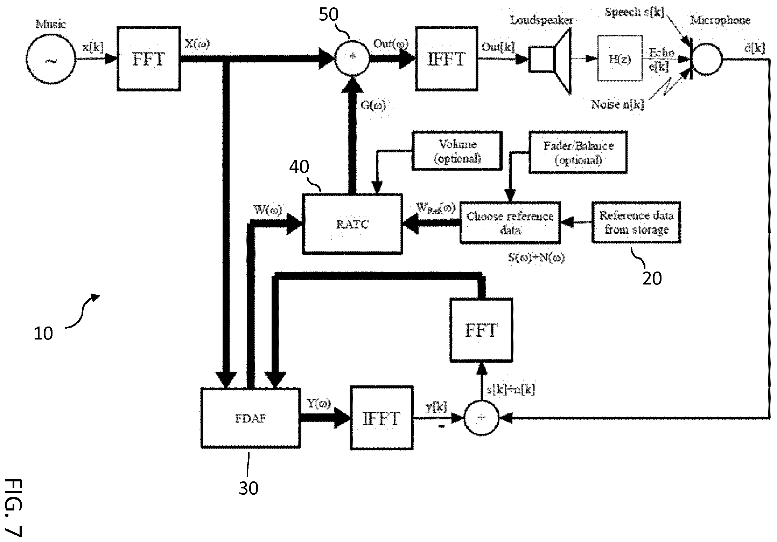

Figure 7 illustrates a schematic drawing of a further system for correcting audio characteristics of a sound signal in a listening environment, according to embodiments of the invention.

In particular, Figure 7 depicts a signal flow diagram of a variant of the RATC method. The implementation of the RATC algorithm of the embodiment is implemented in the frequency domain. Of course, it can also be implemented in the time domain or in the subband range, i.e. by means of a filter bank, or the like.

Regardless of the implementation, the RATC basic system needs at least the following functions:

A module by which the current overall room transfer function can be estimated, which can be achieved for example by an Acoustic Echo Cancellation (AEC) system, which can be performed in the time domain as shown in Figure 5 or in the frequency domain as shown in Figure 7.

Reference data, e.g. the above-mentioned overall room transfer function, must be stored in a data storage. Reference data as used in different embodiments can comprise an impulse response, a magnitude frequency response or a magnitude frequency response in the Bark frequency range, and thereby reflects the reference situation, i.e. the spatial characteristics of the listening environment that prevailed after the tuning. Reference data usually comprises the whole RIR recorded at the same location at which also the microphone is located during real-time operation, when the vehicle is fully closed. The overall room transfer function results when all channels, together with active acoustic system, including tuning, play and at a certain place in the room the resulting RIR is estimated.

A module for calculating the difference between the currently estimated overall transfer function and the reference data. This difference defines an equalizing filter, with which all channels must then be equally affected by the equalization, as already mentioned above, in order that no further, unintentional, alteration of the acoustics (stage width, stage spacing, enveloping, etc.) is effected.

All other additional blocks shown in Figure 7, as well as the domain in which the computation takes place, or the resulting equalizing filter $G(\omega)$ applied (it could also be applied, for example, in the time domain), are only optional.

For example, it is useful if, depending on the fader-balance setting, different reference data sets are stored in the memory, which can then be interpolated to obtain a higher granularity with which the measured, overall RIR is then compared, in order to prevent otherwise inevitable errors.

In addition, the RATC system can also be efficiently combined with other system for correcting audio characteristics of a sound signal in a listening environments known in the art, as described in the following.

As already mentioned above, the RATC method can be embedded in the signal processing method, which is known from EP 1 619793 A1 (DEC) or from the document WO 2015/010865 A1 (ALC), quite simply and elegantly. How this can be done is explained below.

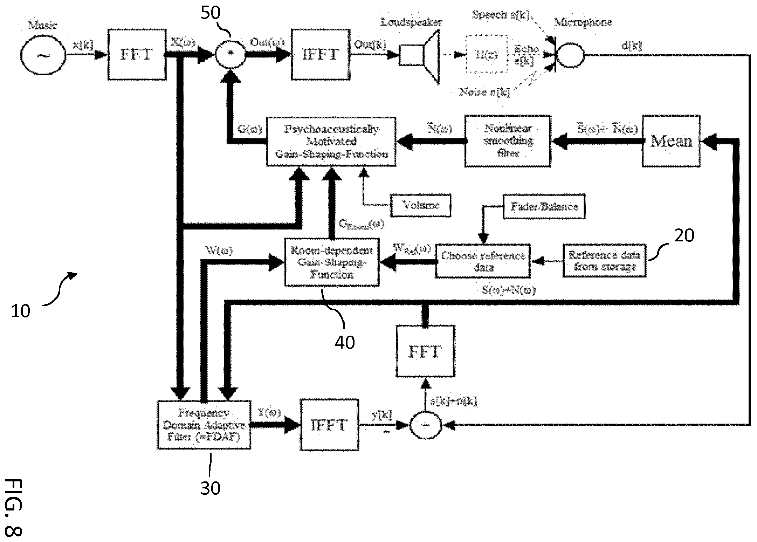

Figure 8 illustrates a schematic drawing of a system for correcting audio characteristics of a sound signal in a listening environment combined with a DEC system, according to embodiments of the invention.

In particular, Figure 8 depicts a signal flow diagram of a combination of a DEC system known from the document EP 1 619793 A1 with the frequency domain variant of the RATC method disclosed in Figure 7.

As illustrated in Figure 8, an adaptive filter already exists in the DEC system, which is implemented in the spectral range. Although this is not directly apparent in Figure 8, the system also comprises a method for the adaptive calculation of the adaptation step size, which was implemented according to the purely statistical method according to the document "Robust and elegant, purely statistical adaptation of acoustic echo canceller and postfilter" by Enzner, G. and Vary, P. (2003).

Thus, the DEC system already contains a robust estimation method for the RIR, which is referred to in FIG. 8 as $W(\omega)$. Using the reference room impulse response $W_{ref}(\omega)$, which is loaded according to the current fader / balance setting from the data storage as described above, a room-dependent equalizing $G_{room}(\omega)$ is calculated by a comparison of its (smoothed) spectra, e.g. in the Bark frequency scale.

The calculated $G_{room}(\omega)$ is then passed on to the signal processing block "Psychoacoustically Motivated Gain Shaping Function", in which the calculation of the background noise-dependent equalization is calculated, in order to be combined therewith, which ultimately results in the equalizing filter $G(\omega)$.

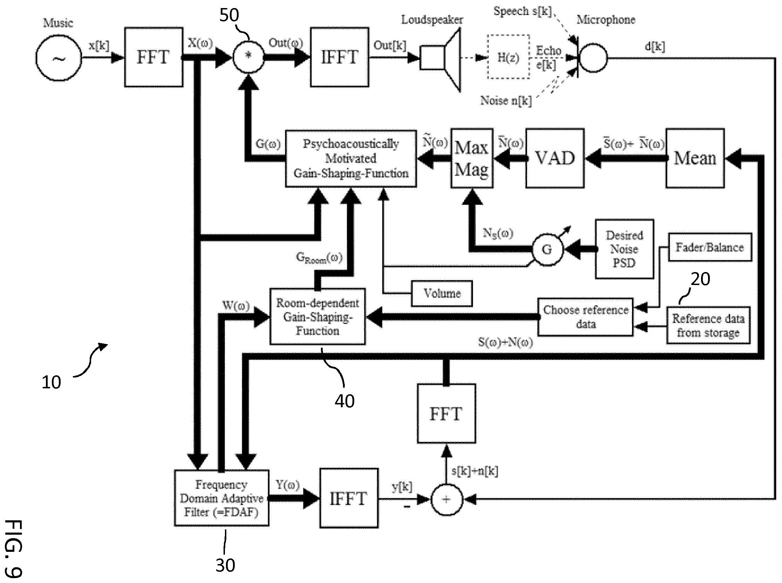

Figure 9 illustrates a schematic drawing of a further system for correcting audio characteristics of a sound signal in a listening environment combined with an ALC system, according to embodiments of the invention.

In particular, Figure 9 depicts a signal flow diagram of a combination of an ALC system known from WO 2015/010865 A1 with a variant of the RATC method.

Figure 9 shows that the RATC algorithm can be integrated into the ALC system as well as into the DEC system in exactly the same way. Thus, Figure 9 illustrates an algorithm that is capable of:

1. Responding to a dynamically changing background noise in a psychoacoustically correct manner (DEC),

2. broadcast input signals in a psychoacoustically correct loudness (ALC), and

3. adaptively react to room-dependent changes of the sound color (RATC),

without the need for a substantial plus of effort in comparison to the three individual methods, since, as illustrated in Figure 9, these methods can be combined in an efficient and elegant manner.

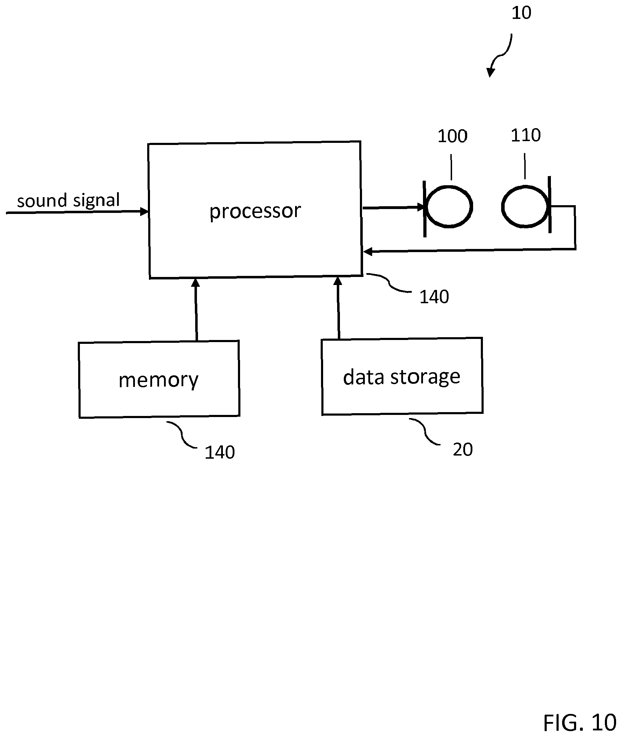

Figure 10 illustrates a schematic drawing of a system for correcting audio characteristics of a sound signal in a listening environment, according to embodiments of the invention.

The system for correcting audio characteristics of a sound signal in a listening environment 10 as depicted in figure 10 comprises a data storage 20, at least one audio loudspeaker 100 for generating a sound output from a sound signal, at least one sensor 110 for obtaining a total sound signal representative of the total sound level in said environment, a memory 130 configured to store program code, at least one processor 140 coupled with the memory 130 and configured to execute the program code, wherein execution of the program code causes the at least one processor 140 to perform the following steps. In a first step, a reference room transfer function of the listening environment is provided. In a further step, a changed room transfer function is adaptively determined, wherein the changed room transfer function is different from the reference room transfer function and is caused by changes of spatial characteristics of the listening environment. In an additional step, equalizing parameters are determined for the sound signal based on the reference room transfer function using the changed room transfer function, in order to compensate for the changed room transfer function. In a further step, the determined equalizing parameters are applied to the sound signal.

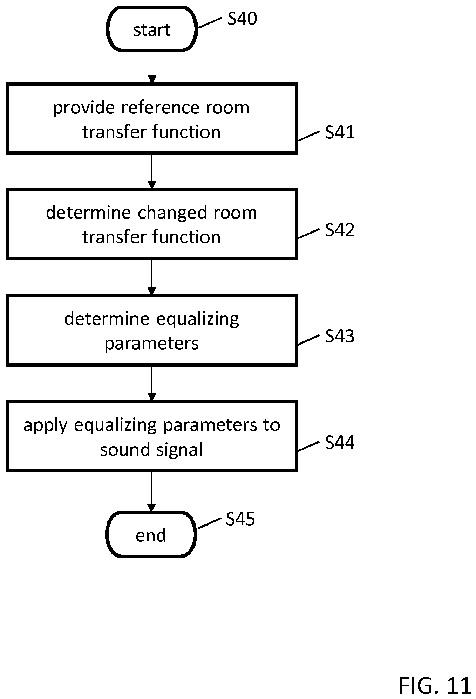

Figure 11 illustrates a flowchart with steps for performing a method for correcting audio characteristics of a sound signal in a listening environment, according to embodiments of the invention.

The method starts in step S40. In step S41, a reference room transfer function of the listening environment is provided. In step S42, a changed room transfer function is adaptively determined, wherein the changed room transfer function is different from the reference room transfer function and is caused by changes of spatial characteristics of the listening environment. In step S43, equalizing parameters are determined for the sound signal based on the reference room transfer function using the changed room transfer function, in order to compensate for the changed room transfer function. In step S44, the determined equalizing parameters are applied to the sound signal. The method ends in step S45.

Summarizing, a method for correcting audio characteristics of a sound signal in a listening environment is provided, wherein a reference room transfer function of the listening environment is provided, and wherein a changed room transfer function is adaptively determined, which is caused by changes of spatial characteristics of the listening environment. Based on the reference room transfer function using the changed room transfer function equalizing parameters are determined for the sound signal.

From the above said, some general conclusions can be drawn:

At least one step of the method, or all steps, can be performed in the time domain. At least one step of the method, or all steps can be performed in the frequency domain. By performing one or all steps of the method in the time or frequency domain, the method can be performed faster and more precisely according to audio requirements and synergies to existing sound systems can be used.

The reference room transfer function can be provided from a data storage. In the data storage, reference data can be provided, which represent a reference room according predefined audio requirements or audio quality requirements.

Adaptively determining a changed room transfer function can further include the steps of broadcasting the sound signal in the listening environment, measuring the broadcast sound signal in the listening environment, and comparing the measured sound signal and the sound signal to adaptively determine a changed room transfer function. A variably changing listening environment can be taken into account by such a real time measurement and the audio characteristics can be adjusted accordingly in a more precise and flexible manner.

Determining equalizing parameters for the sound signal can comprise the steps of calculating a difference between the changed room transfer function and the reference room transfer function, and determining equalizing parameters based on the difference between the changed room transfer function and the reference room transfer function. Equalizing parameters determined based on a difference between the changed room transfer function and the reference room transfer function, enable a more precise and correction of audio characteristics based on the changes of spatial characteristics of the listening environment.

The equalizing parameters can be applied to the output signals for each output channel equally, wherein only audio characteristic, such as the timbre of a sound signal within the listening environment are affected, wherein no further phase induced effects occur.

The changed room transfer function can further be caused by one of a plurality of output channel volume settings, which provides at least two output channel volumes in the listening environment different from each other, in particular the output channel volume settings can be fader and/or balance settings of the audio system, and wherein the reference room transfer function is predetermined for each of the output channel volume settings. Using predetermined reference room transfer functions for each of the output channel volume settings enables a faster and more precise correction of audio characteristics of the listening environment, as the changed room transfer function can be faster and more reliably based on changes of the spatial characteristics of the listening environment.

The reference room transfer function can be determined at reference listening environment conditions, whereby the audio characteristics can be corrected in such a way, that the reference data is obtained at the best possible quality.

The reference and changed room transfer functions can be one one of the group of frequency responses of the listening environment, room impulse responses of the listening environment, magnitude frequency responses of the listening environment, and magnitude frequency responses of the listening environment in a psychoacoustically motivated frequency scale, such as the Bark Frequency Scale. The reference data can further be exactly one of the group above. By using one of the above group as room transfer functions, the acoustic characterization of the listening environment can be performed in a more flexible and memory-saving manner, wherein only relevant data for the audio characteristics to be corrected is used.

The changed room transfer function can be determined using adaptive adjustment of adaption step size, wherein only changes of spatial characteristics of the listening environment are taken into account. Adaptive adjustment of adaption step size enables reliably correcting changes of audio characteristics based on changes of spatial characteristics of the listening environment, wherein other distortions such as impulse-shaped sudden noises or changes of the background noise remain unconsidered.

The method according to the invention can be combined with a dynamic equalizing control algorithm for automatically adjusting the gain of a sound signal to correct varying background noise levels, wherein the steps of adaptively determining a changed room transfer function and applying the determined equalizing parameters to the sound signal are performed by the dynamic equalizing control algorithm, more precisely by its adaptive filter (AEC) realized e.g. in the time or frequency domain. The method according to the invention can be combined with an automatic loudness control (ALC) algorithm for automatically adjusting the gain of a sound signal to correct signal variations in the sound signal, wherein the steps of adaptively determining a changed room transfer function and applying the determined equalizing parameters to the sound signal are performed by the ALC algorithm. Also a combination with a DEC and ALC system at the same time can be advantageously performed. By the combination synergy effects can be used, wherein existing system elements in hardware or software can be utilized, thus reducing the complexity and cost in design and production of related systems. Therein, in particular, RATC differs from DEC, in that a reference is dependent from a Fader/Balance regulation, wherein the reference is compared with the present RIR obtained from FDAF in DEC, and that from this a room-dependent EQ is generated.

An improved method for correcting audio characteristics of a sound signal in a listening environment is provided, which corrects audio characteristics of a sound signal in a listening environment caused by changes of spatial characteristics of the listening environment. The method can advantageously be combined with an already equalized sound system including for example a DEC and/or ALC system.

List of reference signs

1    measured SPL, subwoofer, left window open
2    measured SPL, subwoofer, right window open
3    measured SPL, subwoofer, both windows open

4    measured SPL, audio system, left window open
5    reference SPL
6    SPL difference

10   system for correcting audio characteristics
20   data storage
30   room transfer function determination module
40   equalizing parameter determination module
50   equalizing parameter application module

S40   start
S41   provide reference room transfer function
S42   determine changed room transfer function
S43   determine equalizing parameters
S44   apply equalizing parameters to sound signal
S45   end

**Claims**

1.   A method for correcting audio characteristics of a sound signal in a listening environment, the method comprising:

- providing a reference room transfer function of the listening environment (S41);
- adaptively determining a changed room transfer function, wherein the changed room transfer function is different from the reference room transfer function and caused by changes of spatial characteristics of the listening environment (S42);
- determining equalizing parameters for the sound signal based on the reference room transfer function using the changed room transfer function (S43), in order to compensate for the changed room transfer function; and
- applying the determined equalizing parameters to the sound signal (S44).

2.   The method according to one of the preceding claims, wherein the reference room transfer function is provided from a data storage.

3.   The method according to one of the preceding claims, wherein the adaptively determining a changed room transfer function further includes:

- broadcasting the sound signal in the listening environment;
- measuring the broadcast sound signal in the listening environment at the same location where the reference data had been recorded; and
- comparing the measured sound signal and the sound signal to adaptively determine a changed room transfer function.

4.   The method according to one of the preceding claims, wherein determining equalizing parameters for the sound signal comprises:

- calculating a difference between the changed room transfer function and the reference room transfer function; and
- determining equalizing parameters based on the difference between the changed room transfer function and the reference room transfer function;

5.   The method according to one of the preceding claims, wherein the equalizing parameters are applied to the output signals for each of a plurality of output channels equally.

6.   The method according to one of the preceding claims, wherein the changed room transfer function is further caused by one of a plurality of output channel volume settings, which provides at least two output channel volumes in the listening environment different from each other.

7.   The method according to claim 6, wherein the output channel volume settings are fader and/or balance settings of the audio system.

8. The method according to one of claims 6 and 7, wherein the reference room transfer function is predetermined for each of the output channel volume settings.

9. The method according to one of the preceding claims, wherein the reference room transfer function is determined at reference listening environment conditions.

10. The method according to one of the preceding claims, wherein the reference and changed room transfer functions are one of frequency responses of the listening environment, room impulse responses of the listening environment, magnitude frequency responses of the listening environment, and magnitude frequency responses of the listening environment in the Bark Frequency Scale.

11. The method according to one of the preceding claims, wherein the changed room transfer function is determined using adaptive adjustment of adaption step size, wherein only changes of spatial characteristics of the listening environment are taken into account.

12. The method according to one of claims 1 to 11, wherein the method is combined with a dynamic equalizing control (DEC) algorithm for automatically adjusting the gain of a sound signal to correct varying background noise levels, wherein the steps of adaptively determining a changed room transfer function and applying the determined equalizing parameters to the sound signal are performed by the DEC algorithm.

13. The method according to one of claims 1 to 11, wherein the method is combined with an automatic loudness control algorithm (ALC) for automatically adjusting the gain of a sound signal to correct signal variations in the sound signal, wherein the steps of adaptively determining a changed room transfer function and applying the determined equalizing parameters to the sound signal are performed by the ALC algorithm.

14. A system for correcting audio characteristics of a sound signal in a listening environment, the system (10) comprising:

- a data storage (20), which is configured to provide a reference room transfer function of the listening environment;
- a room transfer function determination module (30), which is configured to adaptively determine a changed room transfer function, wherein the changed room transfer function is caused by changes of spatial characteristics of the listening environment and different from the reference room transfer function,
- an equalizing parameter determination module (40), which is configured to determine equalizing parameters based on the reference room transfer function using the changed room transfer function; and
- an equalizing parameter application module (50), which is configured to apply the equalizing parameters to the sound signal, in order to correct audio characteristics of the sound signal.

15. A system for correcting audio characteristics of a sound signal in a listening environment, comprising:

- a data storage (20),
- at least one audio loudspeaker (100) for generating a sound output from a sound signal;
- at least one sensor (110) for obtaining a total sound signal representative of the total sound level in said environment,
- a memory (130) configured to store program code,
- at least one processor (140) coupled with the memory (130) and configured to execute the program code, wherein execution of the program code causes the at least one processor (140) to perform the following:

- providing a reference room transfer function of the listening environment;
- adaptively determining a changed room transfer function, wherein the changed room transfer function is different from the reference room transfer function and caused by changes of spatial characteristics of the listening environment;
- determining equalizing parameters for the sound signal based on the reference room transfer function using the changed room transfer function, in order to compensate for the changed room transfer function; and
- applying the determined equalizing parameters to the sound signal.

16. The system for correcting audio characteristics of a sound signal in a listening environment according to claim 14 or claim 15, wherein the system (10) is further configured to perform the method according to one of claims 2 to 13.

17. A vehicle comprising a system for correcting audio characteristics (10) of a sound signal in a listening environment according to one of claims 14 to 16.

FIG. 1a

FIG. 1b

SPL measurement with subwoofer and left
window open

FIG. 2a

FIG. 2b

SPL measurement with subwoofer and right
window open

FIG. 3a

FIG. 3b

**SPL measurement with subwoofer and both windows open**

FIG. 4a

FIG. 4b

SPL measurement with onboard audio
system and left window open

FIG. 5

10

sound signal $X$ → **equalizing parameter application module** → corrected sound signal

50

equalizing parameters G

**equalizing parameter determination module** ← reference room transfer function $W_{ref}$ — **data storage**

40

20

changed room transfer function W

**room transfer function determination module**

30

FIG. 6

EP 3 445 069 A1

FIG. 7

FIG. 8

FIG. 9

10

100   110

sound signal → processor

memory

data storage

140

140

20

FIG. 10

start — S40

provide reference room transfer function — S41

determine changed room transfer function — S42

determine equalizing parameters — S43

apply equalizing parameters to sound signal — S44

end — S45

FIG. 11

Europäisches
Patentamt

European
Patent Office

Office européen
des brevets

# EUROPEAN SEARCH REPORT

Application Number

EP 17 18 6678

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | FERREIRA AN PRG A-BAL J S ET AL: "Adaptive Audio Equalization of Rooms Based on a Technique of Transparent Insertion of Acoustic Probe Signals", AES CONVENTION 120; MAY 2006, AES, 60 EAST 42ND STREET, ROOM 2520 NEW YORK 10165-2520, USA, 23 May 2006 (2006-05-23), XP040507632, | 1-5, 9-11, 14-17 | INV. H04S7/00 ADD. H03G5/16 |
| Y | * sections 1-3, 7-9, 11.2, 11.5, 12 * * figures 2-4,22 * | 12,13 | |
| X | US 5 506 910 A (MILLER GARY L [US] ET AL) 9 April 1996 (1996-04-09) * column 3, paragraph 32 - column 4, paragraph 10 * * column 4, line 21 - line 30 * * column 6, line 19 - line 50 * * column 7, line 34 - line 57 * * column 7, line 58 - column 8, line 34 * * column 8, line 50 - column 9, line 19 * * figures 1-2,4-5 * | 1-9, 14-17 | |
| X | David Klutz: "Real-Q2: Real-time adaptive equalizer", , 31 December 2003 (2003-12-31), pages 1-4, XP055451754, Retrieved from the Internet: URL:http://www.prase.it/files/PDF/Real-Q2-Brochure.pdf [retrieved on 2018-02-15] * the whole document * | 1-9, 14-16 | TECHNICAL FIELDS SEARCHED (IPC) H04S H03G H04R |
| Y | US 2016/181999 A1 (CHRISTOPH MARKUS [DE] ET AL) 23 June 2016 (2016-06-23) * paragraphs [0005], [0006] * * paragraph [0015] * * paragraph [0044] * * figure 2 * | 12,13 | |

The present search report has been drawn up for all claims

| Place of search | Date of completion of the search | Examiner |
|---|---|---|
| The Hague | 16 February 2018 | Valenzuela, Miriam |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 3 445 069 A1**

## ANNEX TO THE EUROPEAN SEARCH REPORT
## ON EUROPEAN PATENT APPLICATION NO.

EP 17 18 6678

This annex lists the patent family members relating to the patent documents cited in the above-mentioned European search report.
The members are as contained in the European Patent Office EDP file on
The European Patent Office is in no way liable for these particulars which are merely given for the purpose of information.

16-02-2018

| Patent document cited in search report | | Publication date | Patent family member(s) | | Publication date |
|---|---|---|---|---|---|
| US 5506910 | A | 09-04-1996 | NONE | | |
| US 2016181999 | A1 | 23-06-2016 | CN | 105453594 A | 30-03-2016 |
| | | | EP | 3025517 A1 | 01-06-2016 |
| | | | US | 2016181999 A1 | 23-06-2016 |
| | | | WO | 2015010865 A1 | 29-01-2015 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1619793 A1

- WO 2015010865 A1

**Non-patent literature cited in the description**

- **YAMAMOTO, S. ; KITAYAMA, S. ; TAMURA, J. ; ISHIGAMI, H.** *An adaptive echo canceller with variable step gain method,* 1982

- **ENZNER, G. ; VARY, P.** *Robust and elegant, purely statistical adaptation of acoustic echo canceller and postfilter,* 2003